(19) **Europäisches Patentamt**

**European Patent Office**

**Office européen des brevets**

(11) Veröffentlichungsnummer: **0 243 878**

**A1**

(12) **EUROPÄISCHE PATENTANMELDUNG**

(21) Anmeldenummer: **87105950.7**

(22) Anmeldetag: **23.04.87**

(51) Int. Cl.⁴: **H03K 3/354** , H03K 3/023

(30) Priorität: **28.04.86 DE 3614316**

(43) Veröffentlichungstag der Anmeldung:
**04.11.87 Patentblatt 87/45**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Schreilechner, Peter, Ing.**
**Alt-Ossiach 99**
**D-9570 Ossiach(DE)**

(54) **Integrierte NMOS-Schaltungsanordnung.**

(57) Die integrierte NMOS-Schaltungsanordnung eignet sich beim Anschluß eines externen Kondensators (C) als spannungsgesteuerter Oszillator (VCO), dessen Frequenz im Aussteuerbereich linear abhängig und dessen Empfindlichkeit im Aussteuerbereich unabhängig von der Steuerspannung (Ust) ist. Eine schaltbare Ladestromquelle (I1;M9) lädt den Kondensator (C) über alle Frequenzen in konstanter Zeit auf und eine schaltbare Entladestromquelle (I2;M4 bis M8,M10,M11,R1) entlädt den Kondensator (C) in einer von der Steuerspannung (Ust) abhängigen Zeit. Der Umschaltpunkt wird durch einen Schmitt-Trigger mit Inverter (ST) bestimmt, der auf die Stromquellen rückgekoppelt ist. Eine Kompensation von Temperatur-und Versorgungsspannungsschwankungen (TK) ist vorgesehen.

FIG 2

EP 0 243 878 A1

## Integrierte NMOS-Schaltungsanordnung

Die Erfindung betrifft eine integrierte NMOS-Schaltungsanordnung nach dem Oberbegriff des Patentanspruchs 1.

Eine derartige Schaltungsanordnung eignet sich insbesondere beim Anschluß eines externen Kondensators als spannungsgesteuerter Oszillator (VCO). Üblicherweise besitzen spannungsgesteuerte Oszillatoren einen frequenzbestimmenden Kondensator, der abhängig von einer Steuerspannung aufgeladen und entladen wird und somit eine spannungsgesteuerte Frequenz erzeugt. Unter Verwendung von komplementären Transistoren ist eine derartige Schaltungsanordnung verhältnismäßig einfach aufzubauen. Schwierigkeiten ergeben sich, wenn nur Transistoren eines Typs zur Verfügung stehen.

In integrierten Schaltungsanordnungen mit NMOS-Transistoren wird üblicherweise ein frequenzbestimmender externer Kondensator über einen spannungsgesteuerten Widerstand, der als Transistornetzwerk ausgebildet ist, auf-und entladen. Die Rückkopplung der Ladespannung erfolgt über einen Komparator mit Inverter, der über einen Vergleich mit einer Referenzspannung den Kippzeitpunkt der Schaltung bestimmt. Der Nachteil einer derartigen Schaltungsanordnung liegt darin, daß über den gesamten Aussteuerbereich eine inhärente Nichtlinearität der Frequenz des VCO als Funktion von der Steuerspannung vorhanden ist und daß somit auch die Empfindlichkeit, d.h. das Verhältnis von Frequenzänderung zu Steuerspannungsänderung nichtlinear ist. Eine typische Empfindlichkeitskurve für eine auf die Ruhefrequenz des VCO normierte Frequenz in Abhängigkeit von der Steuerspannung zeigt die Kurve 1 der Figur 4 der Zeichnung.

Der Erfindung liegt die Aufgabe zugrunde, eine integrierte NMOS-Schaltungsanordnung anzugeben, mit der sich beim Anschluß eines externen Kondensators ein spannungsgesteuerter Oszillator realisieren läßt, dessen Frequenz über den Aussteuerbereich weitgehend linear abhängig von der Steuerspannung und dessen Empfindlichkeit im gesamten Aussteuerbereich weitgehend konstant ist.

Diese Aufgabe wird bei einer Schaltungsanordnung der eingang genannten Art erfindungsgemäß durch die Merkmale des kennzeichnenden Teils des Patentanspruchs 1 gelöst.

Das Wesen der Erfindung besteht darin, mit Hilfe einer spannungsgesteuerten Stromquelle eine linear von der Steuerspannung abhängige Entladezeit eines extern an die integrierte Schaltungsanordnung anzuschließenden Kondensators zu erhalten und die Aufladezeit über alle Frequenzen konstant zu halten. Dabei wird die Aufladezeit über eine von der Steuerspannung unabhängige Ladestromquelle klein gegenüber der Periodendauer gehalten. Die erfindungsgemäße integrierte Schaltungsanordnung gewährleistet damit beim Anschluß eines externen Kondensators einen linearen Zusammenhang zwischen der Steuerspannung und der Frequenz des VCO. Die Schaltungsanordnung besitzt den weiteren Vorteil, daß sie einen geringen Design-Aufwand erfordert.

Eine weitere Aufgabe besteht darin, eine Kompensation von Temperatur-und Versorgungsspannungsschwankungen vorzusehen.

Diese weitere Aufgabe wird bei einer erfindungsgemäßen Schaltungsanordnung durch eine temperatur-und versorgungsspannungsabhängige Kompensation des Entladestroms der spannungsgesteuerten Entladestromquelle gelöst.

Weitere Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert.

Es zeigt:

Fig. 1 ein Prinzipschaltbild einer erfindungsgemäßen integrierten Schaltungsanordnung mit extern angeschlossenem Kondensator,

Fig. 2 ein Schaltbild einer konkreten Ausführungsform einer erfindungsgemäßen integrierten Schaltungsanordnung mit extern angeschlossenem Kondensator,

Fig. 3 ein Schaltbild einer konkreten Ausführungsform einer erfindungsgemäßen integrierten Schaltungsanordnung mit einer Ab-und Umschalteinrichtung und

Fig. 4 ein Diagramm mit Vergleichskurven einer auf eine Ruhefrequenz normierten Frequenz in Abhängigkeit von der Steuerspannung eines spannungsgesteuerten Oszillators.

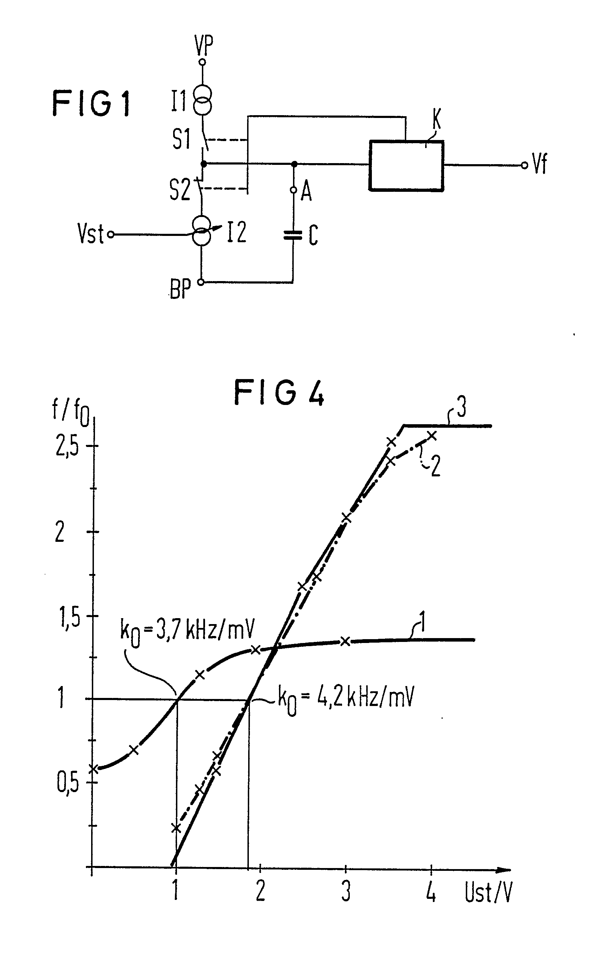

Fig. 1 gibt ein Prinzipschaltbild eines spannungsgesteuerten Oszillators mit einer erfindungsgemäßen integrierten Schaltungsanordnung und einem extern zwischen eine Klemme A und eine Bezugsspannungsklemme BP geschalteten Kondensator C an. Der Kondensator C bestimmt die Frequenz des VCO und wird von umschaltbaren Stromquellen I1 und I2 geladen und entladen. Zur Steuerung der Schalter S1 und S2 dient ein Kontrollnetzwerk K. Im einzelnen liegt die Steuerspannung an der Steuerspannungsklemme Vst, die mit der Stromquelle I2 verbunden ist, um ihren Strom zu steuern. Ein Pol der Stromquelle I2 liegt an der Bezugsspannungsklemme BP, der andere Pol an einem Kontakt des in Serie liegenden Schalters S2. Der andere Kontakt des Schalters S2 ist mit einem Kontakt des in Serie liegenden Schalters S1 verbunden, dessen anderer Kontakt mit einem Pol der wiederum in Serie liegenden Stromquelle I1 liegt, deren anderer Pol an einer Versorgungsspannungsklemme VP angeschlossen ist.

Der Verbindungspunkt der beiden Schalter S1 und S2 ist mit der Klemme A, an der der Kondensator C angeschlossen ist, und mit dem Eingang des als Block gezeichneten Kontrollnetzwerks K verbunden. Ein Ausgang des Kontrollnetzwerks K ist mit der Ausgangsklemme Vf der integrierten Schaltungsanordnung verbunden, der andere steuert die Schaltstellungen der Schalter S1 und S2. Gemäß Fig. 1 ist der Schalter S1 geöffnet und der Schalter S2 geschlossen, so daß der Kondensator C über die Stromquelle I2 abhängig von der Steuerspannung entladen wird.

Durch Schließen des Schalters S1 und Öffnen des Schalters S2 wird der Kondensator C unabhängig von der Steuerspannung aufgeladen. Um einen Querstrom zu vermeiden, müssen die Schalter S1 und S2 antivalent ein-bzw. ausgeschaltet werden. Vorzugsweise enthält daher das Kontrollnetzwerk K einen Schmitt-Trigger mit Invertern, dessen bzw. deren Ausgänge mit den Steuerelementen der Schalter S1 und S2 und der Ausgangsklemme Vf verbunden sind.

Um eine über alle Frequenzen kurze Aufladezeit des Kondensators zu erreichen, muß der Strom durch die Ladestromquelle I1 groß sein. Andererseits wird der Kondensator bei einer kleinen Steuerspannung über einen längeren Zeitraum entladen als bei einer hohen Steuerspannung. Am Eingang des Kontrollnetzwerks K liegt deshalb eine Sägezahnspannung mit einer für alle Frequenzen gleichen Anstiegszeit, aber einer steuerspannungsabhängigen Rückzeit. Ein im Kontrollnetzwerk vorgesehener Schmitt-Trigger wandelt die am Eingang anliegende Sägezahnspannung in eine Rechteckspannung gleicher Frequenz um.

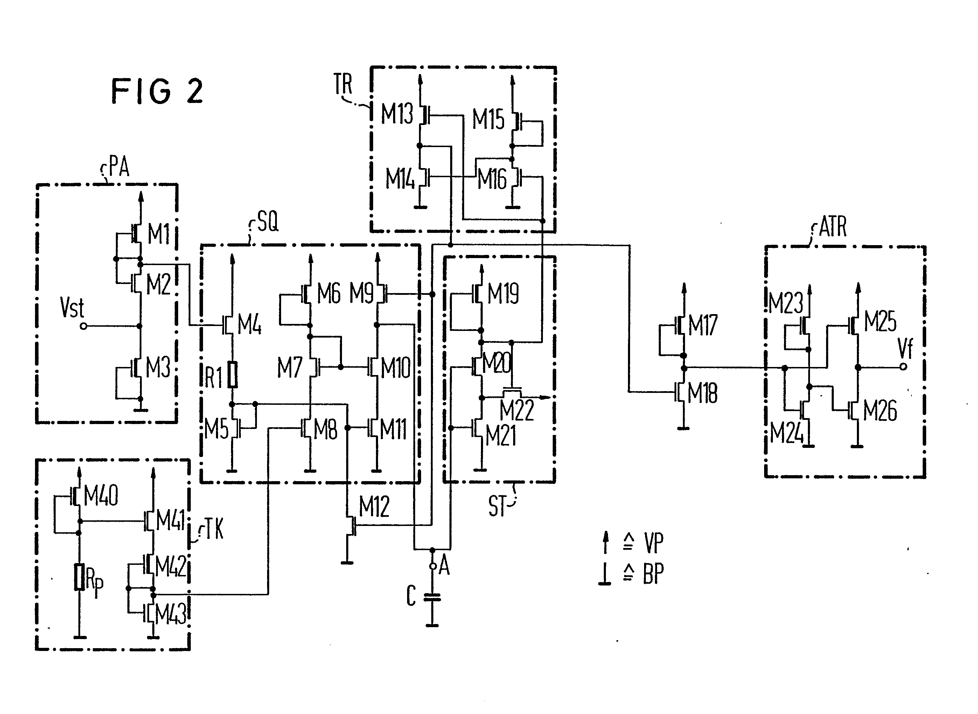

Fig. 2 zeigt ein Schaltbild eines spannungsgesteuerten Oszillators mit einer konkreten Ausführungsform einer erfindungsgemäßen integrierten Schaltungsanordnung mit einem extern angeschlossenen Kondensator. Gemäß der Gattung der Erfindung sind nur MOS-Transistoren vom n-Kanal-Typ als Anreicherungs-und Verarmungstransistoren verwendet. Um die Übersichtlichkeit des Schaltbildes zu erhöhen, sind gestrichelt einzelne Schaltungsteile umrandet, die jeweils eine bestimmte Funktion erfüllen. Der spannungsgesteuerte Oszillator möge im Ausführungsbeispiel eine Ruhefrequenz von z.B. $f_o$ = 4 MHz besitzen, die über die Kapazität des externen Kondensators C einzustellen ist, der einen Wert von 10 bis 50 pF besitzen möge. Die Schaltungsteile PA,SQ und TK bilden ein Transistornetzwerk.

Aufgrund der vorgegebenen Ruhefrequenz von $f_o$, die dem Arbeitspunkt des VCO entspricht, muß die Stromquelle SQ einen Ruhestrom liefern, der von der an der Steuerspannungsklemme Vst liegenden Steuerspannung über einen Pegelanpasser PA abgeleitet wird. Der Aussteuerbereich der Schaltung bewegt sich zwischen Steuerspannungswerten von 0 bis 4 V.

Die Pegelanpassung für die den Ruhestrom steuernde Spannung, bezogen auf die Steuerspannung von 1,9 V bei einem Arbeitspunkt von 4 MHz, geschieht mit Hilfe einer zwischen die Versorgungsspannungsklemmen VP und BP liegenden, aus den Transistoren M1 bis M3 gebildeten Spannungsteilerkette. Die Transistoren M1 und M3 sind als Widerstände geschaltete Transistoren vom Verarmungstyp, bei denen Source und Gate miteinander verbunden sind. In Serie zwischen den Ausgangskreisen der Transistoren M1 und M3 liegt der als Diode geschaltete Transistor M2, der vom Anreicherungstyp ist. Die Steuerspannungsklemme Vst ist mit dem Verbindungspunkt der Ausgangskreise der Transistoren M2 und M3, und der Steuereingang M4 der Stromquelle SQ mit dem Verbindungspunkt der Ausgangskreise der Transistoren M1 und M2 verbunden.

Die Stromquelle SQ enthält eine schaltbare Ladestromquelle und eine schaltbare Entladestromquelle, wobei die Entladestromquelle noch eine Möglichkeit zur Kompensation von Temperatur-und Versorgungsspannungsschwankungen vorsieht.

Als Basiselemente für die Entladestromquelle sind einfache Stromspiegel vorgesehen. Die Umwandlung der pegelangepaßten Steuerspannung in einen proportionalen Strom erfolgt über den aus den Transistoren M4 und M5 und den Widerstand R1 gebildeten Eingangskreis eines ersten Stromspiegels. Am Gate des Transistors M4 liegt die pegelangepaßte Steuerspannung und die Ausgangsklemmen des Transistors M4 sind einerseits mit der Versorgungsspannungsklemme VP und andererseits über den Widerstand R1 mit dem als Diode geschalteten. an die Bezugsspannungsklemme BP angeschlossenen Transistor M5 verbunden.

Für ein lineares Verhalten ist es notwendig, daß der Transistor M4 im ungesättigten Bereich arbeitet. Dementsprechend sind der Transistor M5 und der Widerstand R1 zu dimensionieren. Der im Eingangskreis des Stromspiegels fließende Strom wird dann auf den Strompfad mit den Transistoren M10, M11 und dem Kondensator C gespiegelt. Der mit seinem Ausgangskreis in Serie zum Ausgangskreis des Spiegeltransistors M11 des ersten Stromspiegels liegende Transistor M10 ist der Spiegeltransistor eines zweiten Stromspiegels. dessen Eingangskreis die mit ihren Ausgangskreisen in Serie liegendenden Transistoren M6 bis M8 enthält. Der Transistor M6 ist ein mit der Versorgungsspannungsklemme VP verbundener, als Widerstand geschalteter Verarmungstransistor, der über den als Diode geschalteten Widerstand M7 mit dem Transistor M8 verbunden ist, dessen freier Anschluß mit der Bezugsspannungsklemme BP verbunden ist. Die Steueranschlüsse der Transistoren M7 und M10 sind miteinander verbunden, wobei diese Transistoren den zweiten Stromspiegel bilden.

Für die an sich bekannten Stromspiegel ist es notwendig, daß die jeweilige Stromspiegelschaltung im Sättigungsbereich arbeitet. Das ist der Fall, wenn die Gate-Source-Spannung die Transistorschwellspannung überschreitet, wobei bei dem als Diode geschalteten Transistor Drain und Gate miteinander verbunden sind. Durch Änderung der Kanallängen der Stromspiegeltransistoren kann der Ausgangswiderstand auf einen gewünschten Wert gebracht werden. Das Übersetzungsverhältnis der Stromspiegel wird durch das Verhältnis der Quotienten aus Kanalweite und Kanallänge der einzelnen Transistoren gegeben.

Der Steueranschluß des Transistors M8 ist mit der Teilschaltung TK zur Kompensation von Temperatur-und Versorgungsspannungsschwankungen verbunden. Als temperaturabhängiges Element wird der mit der Versorgungsspannung verbundene Spannungsteiler aus dem als Widerstand geschalteten Verarmungstransistor M40 und dem Polysilicium-Widerstand Rp verwendet. Der Teilerpunkt ist mit dem Steuereingang eines Transistors M41 verbunden, dessen Ausgangskreis in Serie zu einem als Widerstand geschalteten Verarmungstransistor M42 und einem als Diode geschalteten Transistor M43 liegt, wobei ein Ausgangsanschluß des Transistors M41 mit der Versorgungsspannungsklemme VP und ein Ausgangsanschluß des Transistors M43 mit der Bezugsspannungsklemme BP verbunden ist. Der Verbindungspunkt der Transistoren M42 und M43 ist an den Steuereingang des Transistors M8 gelegt.

Durch das unterschiedliche Temperaturverhalten der Einsatzspannung des Verarmungstransistors M40 und des PolysiliciumWiderstandes Rp kommt es zu einer Spannungsverschiebung am Teilerpunkt des aus ihnen gebildeten Spannungsteilers und damit zu einer Spannungsverschiebung am Steuereingang des Transistors M8 und des Transistors M10. Mit steigender Temperatur wird die Spannung am Steuereingang des Transistors M10 größer und der Transistor M10 leitender. Dies wirkt einer bei einem Temperaturanstieg kleiner werdenden Transistorleitfähigkeit entgegen und führt zu einer Korrektur der Frequenz bei sich ändernder Temperatur.

Mit steigender Versorgungsspannung steigt das Potential am Teilerpunkt des Spannungsteilers aus dem Transistor M40 und dem Widerstand Rp. Damit wird die am Steuereingang des Transistors M10 liegende, auf das an der Bezugsspannungsklemme BP liegende Bezugspotential bezogene Steuerspannung mit steigender Versorgungsspannung kleiner. Dies wirkt dem Ansteigen des Entladestroms über den externen Kondensator C bei höherer Versorgungsspannung entgegen und bewirkt eine Korrektur der Frequenz bei sich ändernder Versorgungsspannung.

Der Transistor M9 stellt die Ladestromquelle für den Kondensator C dar. Ein Ausgangsanschluß ist mit der Versorgungsspannungsklemme VP, der andere mit einem Ausgangsanschluß des Transistors M10 verbunden, dessen Ausgangskreis in Serie zum Ausgangskreis des Transistors M11 liegt, wobei der Verbindungspunkt der Ausgangskreise der Transistoren M9 und M10 an der Klemme A angeschlossen ist, an dem auch ein Anschluß des Kondensators C liegt.

Da es in einer NMOS-Schaltungsanordnung keine Komplementärtransistoren gibt und der Kondensator C bei der Aufladung im Sourcezweig des Ladetransistors M9 liegt, ist eine zur Steuerspannung proportionaler Aufladezeit nur schwer realisierbar. Durch eine Dimensionierung des Transistors M9, dessen Verhältnis aus Kanalweite zu Kanallänge groß gewählt wird, ist bei konstanter Aufladung und kurzer Aufladezeit das Aussteuerverhalten des VCO von der Aufladung weitgehend unabhängig. Lediglich im obersten Frequenzbereich erfolgt durch die konstante Aufladung eine Abweichung von der Linearität des VCO.

Wird der Kondensator C über den Transistor M9 aufgeladen, dann muß der Zweig aus den Transistoren M10 und M11 zur Vermeidung eines Querstroms abgeschaltet werden. Umgekehrt muß der Transistor M9 abgeschaltet werden, wenn der Kondensator C über die Transistoren M10 und M11 entladen wird. Die Abschaltung des Zweiges mit den Transistoren M10 und M11 erfolgt über den Transistor M12, dessen einer Ausgangsanschluß wie der jeweils eine Ausgangsanschluß der Transistoren M5 und M11 des ersten Stromspiegels mit der Bezugsspannungsklemme BP verbunden ist und dessen anderer Ausgangsanschluß mit den beiden jeweils miteinander verbundenen Steueranschlüssen der Transistoren M5 und M11 verbunden ist. Bei einem Durchschalten des Transistors M12 werden damit die Eingangskreise der Transistoren des ersten Stromspiegels kurzgeschlossen.

Die Steueranschlüsse der Transistoren M9 und M12, über die die Transistoren geschaltet werden, werden von einem Schmitt-Trigger mit Inverter ST gesteuert, dem ein Trei ber TR nachgeschaltet ist, wobei der Schmitt-Trigger mit Inverter ST das an der Klemme A liegende Potential erfaßt. Damit wird die an dem Kondensator C liegende Spannung invertiert auf die schaltbaren Stromquellen rückgekoppelt und somit das Schwingen des Oszillators ermöglicht.

Der Schmitt-Trigger mit Inverter ST enthält die Transistoren M20 und M21, wobei die Steueranschlüsse der beiden Transistoren mit der Klemme A verbunden sind und die Ausgangskreise in Serie liegen. In Serie zum Ausgangskreis des Transistors M20 liegt ferner ein mit seinem freien Ende an der Versorgungsspannungsquelle VP angeschlossener, als Widerstand geschalteter Verarmungstransistor M19. Der Verbindungspunkt der Transistoren M19 und M20 bildet den Ausgang des Schmitt-Triggers mit Inverter ST und ist auf den Steuereingang eines Transistors M22 geführt, dessen einer Ausgangsanschluß am Verbindungspunkt der Ausgangskreise der Transistoren M20 und M21 und dessen anderer Ausgangsanschluß an der Bezugsspannungsklemme VP liegt. Der freie Anschluß des Transistors M21 ist mit der Bezugsspannungsklemme BP verbunden. Die Transistoren M21 und M22 bilden einen Spannungsteiler.

Der Treiber TR enthält zwei aus je zwei mit ihren Ausgangskreisen in Serie zwischen die Versorgungsspannung geschaltete Kreise aus den Transistoren M13, M14 und M15, M16. Die Transistoren M13 und M15 sind vom Verarmungstyp und liegen mit ihrem freien Anschluß an der Versorgungsspannungsklemme VP. Der Transistor M15 ist als Widerstand geschaltet. Die freien Anschlüsse der Transistoren M14 und M16 sind mit der Bezugsspannungsklemme BP verbunden. Die Steuereingänge der Transistoren M13 und M16 liegen am Ausgang des Schmitt-Triggers mit Inverter ST und der Steuereingang des Transistors M14 am Verbindungspunkt der Ausgangskreise der Transistoren M15 und M16. Den Ausgang des Treibers TR bildet der Verbindungspunkt der Ausgangskreise der Transistoren M13 und M14, der einerseits auf die Steuereingänge der Transistoren M9 und M12 geschaltet ist und andererseits einen aus den Transistoren M17 und M18 gebildeten Inverter steuert, dessen Ausgang auf den Eingang eines Ausgangstreibers ATR geschaltet ist.

Der Ausgangstreiber ATR enthält eine dem Treiber TR entsprechende Transitoranordnung, wobei sich jeweils die Transistoren M13 und M25, M14 und M26, M15 und M23 sowie M16 und M24 entsprechen. Der Verbindungspunkt der Transistoren M25 und M26 ist mit der Ausgangsklemme Vf der erfindungsgemäßen integrierten Schaltungsanordnung verbunden.

Erhöht man die Eingangsspannung des Schmitt-Triggers mit Inverter ST, dann geht der Ausgang auf den Wert "Low", wenn die Gate-Source-Spannung am Transistor M20 größer als die Schwellspannung dieses Transistors wird. Das ist dann der Fall, wenn die durch den Spannungsteiler aus den Transistoren M21 und M22 gebildete Drain-Source-Spannung des Transistors M21 auf einen Wert kleiner als die Differenz aus der am Kondensator C liegenden Spannung und der Schwellspannung des Transistors M20 absinkt. Die untere Schaltschwelle wird dadurch bestimmt, daß die am Kondensator C liegende Spannung kleiner oder gleich der Summe aus der Schwellspannung des Transistors M20 und der Drain-Source-Spannung des Transistors M21 wird.

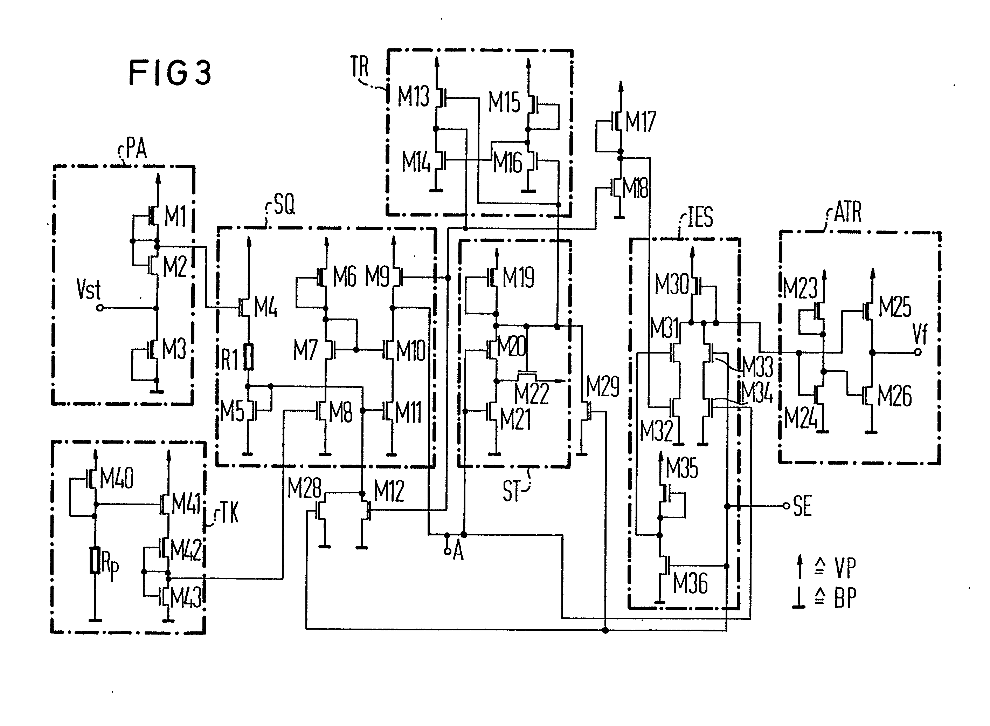

Fig. 3 zeigt ein Schaltbild einer konkreten Ausführungsform einer erfindungsgemäßen integrierten Schaltungsanordnung mit einer Ab-und Umschaltanordnung. Wenn der VCO gemäß Fig. 2 integrierter Bestandteil eines phasengekoppelten Regelkreises (PLL) ist, so kann die Forderung bestehen, die PLL mit einem externen VCO zu betreiben. Dabei wird an der Klemme A wahlweise ein Kondensator C oder der extern anschließbare spannungsgesteuerte Oszillator angeschlossen. Gegenüber dem Schaltbild der Fig. 2 liegt deshalb an der Klemme A nicht mehr der Kondensator C und die Schaltungsanordnung ist um die Transistoren M28, M29 und die Intern/Extern-Schaltung IES erweitert, die jeweils von einer Umschaltklemme SE gesteuert werden. Gleiche Elemente wie in Fig. 2 sind in Fig. 3 mit gleichen Bezugszeichen versehen. Um gemäß diesem Ausführungsbeispiel nach Fig. 3 die Stromquelle SQ abzuschalten, wird der Steuereingang des ersten Stromspiegels aus den Transistoren M5 und M11 sowie der Ausgang des Schmitt-Triggers mit Inverter ST über die Ausgangskreise der Transistoren M28 bzw. 29 - schaltbar mit der Bezugsspannungsklemme BP verbunden, wobei die Steuereingänge der beiden Transistoren mit der Klemme SE verbunden sind.

Die Intern/Extern-Schaltung IES sorgt dafür, daß auch bei einer abgeschalteten Stromquelle SQ der Ausgangstreiber ATR eingeschaltet bleibt. Dazu wird die Schaltung IES von der Klemme SE gesteuert, während die Eingänge der Schaltung mit dem Ausgang des aus den Transistoren M17 und M18 gebildeten Inverters und der Klemme A verbunden sind. Der Ausgang der Schaltung IES liegt am Eingang des Ausgangstreibers ATR.

Die Umschaltung erfolgt über zwei Kreise mit je zwei mit ihren Ausgangskreisen in Serie liegenden Transistoren, die aus den Transistoren M31 und M32 sowie M33 und M34 gebildet werden. Die freien Anschlüsse der Transistoren M32 und M34 liegen an der Bezugsspannungsklemme BP, die freien Anschlüsse der Transistoren M31 und M33 sind miteinander und dem Eingang des Ausgangstreibers ATR sowie über einen als Widerstand geschalteten Verarmungstransistor M30 mit der Versorgungsspannungsklemme VP verbunden. Die Steuerklemme SE ist mit dem Steuereingang des Transistors M33 und über einen aus den Transistoren M35 und M36 gebildeten Inverter mit der Steuerklemme des Transistors M31 verbunden. Der Steuereingang des Transistors M32 liegt am Ausgang des aus den Transistoren M17 und M18 gebildeten Inverters, während der Steuereingang des Transistors M34 an der Klemme A angeschlossen ist.

Das Diagramm gemäß Fig. 4 zeigt drei verschiedene Kurven, die die Abhängigkeit einer auf einer Ruhefrequenz fo bezogenen Frequenz f von einer in Volt angegebenen Steuerspannung Ust angibt. Die Kurve 1 zeigt eine Empfindlichkeitskurve eines VCO mit spannungsgesteuertem Widerstand nach dem Stand der Technik um einen Arbeitspunkt ko = 3,7 kHz/mV. Demgegenüber zeigen die Kurven 2 und 3 die Empfindlichkeit eines VCO mit der erfindungsgemäßen integrierten Schaltungsanordnung. Die Kurve 2 ist dabei eine Meßkurve, während Kurve 3 durch eine Rechnersimulation gebildet wurde. Der Arbeitspunkt dieser beiden Kurven liegt bei ko = 4,2 kHz/mV. Die Kurven 2 und 3 zeigen, daß sich die Empfindlichkeitskennlinie eines VCO mit der erfindungsgemäßen integrierten Schaltungsanordnung im Bereich bis zum 2,5-fachen der Arbeitsfrequenz linear verhält. Die Verstärkung eines derartigen VCO bleibt daher immer konstant.

**Ansprüche**

1. Integrierte NMOS-Schaltungsanordnung mit einem an eine Steuerspannungsklemme angeschlossenen spannungsgesteuerten Transistornetzwerk, das ausgangsseitig an einer ersten Klemme zum Anschluß einer externen Bauelementanordnung, insbesondere eines Kondensators, und an einem Eingang einer Kontrolleinrichtung liegt, deren Ausgang auf das Transistornetzwerk rückgekoppelt und mit einer Ausgangsklemme der Schaltungsanordnung verbunden ist und die über eine Versorgungsspannungsklemme und eine Bezugsspannungsklemme von einer Spannungsquelle versorgt wird,
**dadurch gekennzeichnet,**
daß das Transistornetzwerk (PA,SQ,TK) eine -schaltbare Ladestromquelle (I1;M9) und eine -schaltbare, von einer an der Steuerspannungsklemme (Vst) liegenden Steuerspannung (Ust) gesteuerte Entladestromquelle (I2;M4 bis M8M10,M11,R1) enthält, die von der Kontrolleinrichtung (K;ST,TR) antivalent geschaltet werden.

2. Anordnung nach Anspruch 1,
**dadurch gekennzeichnet,**
daß die schaltbare Ladestromquelle (I1;M9) einen über seinen Steuereingang schaltbaren Transistor (M9) enthält, dessen Ausgangsanschlüsse mit einer Versorgungsspannungsklemme (VP) einerseits und der ersten Klemme (A) andererseits verbunden sind.

3. Anordnung nach Anspruch 1 bis 2,
**dadurch gekennzeichnet,**
daß der schaltbare Transistor (M9) der Ladestromquelle ein großes Verhältnis von Kanalweite zu Kanallänge aufweist.

4. Anordnung nach Anspruch 1 bis 3,
**dadurch gekennzeichnet,**
daß die schaltbare Entladestromquelle (I2;M4 bis M8,M10,M11,R1) einen mit der Steuerspannungsklemme (Vst) verbundenen, aus zwei Transistoren (M5,M11) gebildeten ersten Stromspiegel enthält, in dessen Eingangskreis (M4,M5,R1) ein der Steuerspannung proportionaler Referenzstrom erzeugt wird, der auf den Ausgangskreis des Ausgangstransistors (M11) des ersten Stromspiegels gespiegelt wird.

5. Anordnung nach Anspruch 1 bis 4,
**dadurch gekennzeichnet,**
daß der Eingangskreis (M4,M5,R1) des ersten Stromspiegels einen über seinen Steuereingang mit der Steuerspannungsklemme (Vst) verbundenen ersten Steuertransistor (M4) enthält, dessen Ausgangsanschlüsse mit der Versorgungsspannungsklemme (VP) einerseits und der Serienschaltung aus einem Widerstand (R1) und einem als Diode geschalteten Transistor (M5) des ersten Stromspiegels andererseits verbunden sind.

6. Anordnung nach Anspruch 1 bis 5,
**dadurch gekennzeichnet ,**
daß die schaltbare Entladestromquelle (I2;M4 bis M8,M10,M11,R1) über einen Schalttransistor (M12) geschaltet wird, dessen Ausgangskreis parallel zu den Eingangskreisen der Transistoren (M5,M11) des ersten Stromspiegels liegt.

7. Anordnung nach Anspruch 1 bis 6,
**dadurch gekennzeichnet,**
daß die schaltbare Entladestromquelle (I2;M4 bis M8,M12,M11,R1) eine Schaltungsanordnung zur Kompensation von Temperatur-und Versorgungsspannungsänderungen (M40 bis M43,M6 bis M8,M10,Rp) aufweist.

8. Anordnung nach Anspruch 1 bis 7,
**dadurch gekennzeichnet,**
daß ein an die Versorgungsspannungsklemme (VP) geschalteter, aus einem als Widerstand geschalteten ersten Verarmungstransistor (M40) und einem Polysilicium-Widerstand (Rp) gebildeter Spannungsteiler (Rp,M40) vorgesehen ist, dessen Teilerpunkt mit einem aus zwei weiteren Transistoren (M7,M8) gebildeten zweiten Stromspiegel verbunden ist, in dessen Eingangskreis (M6 bis M8) ein temperatur-und versorgungsspannungsabhängiger Strom erzeugt wird, der auf den Ausgangskreis des Ausgangstransistors (M10) des zweiten Stromspiegels gespiegelt wird.

9. Anordnung nach Anspruch 1 bis 8,
**dadurch gekennzeichnet,**
daß der Eingangskreis des zweiten Stromspiegels (M6 bis M8) einen mit der Versorgungsspannungsklemme (VP) verbundenen, als Widerstand geschalteten zweiten Verarmungstransistor (M6) in Serie zu einem als Diode geschalteten Transistor (M7) des zweiten Stromspiegels und zum Ausgangskreis eines zweiten Steuertransistors (M8) enthält, dessen Steuereingang am Verbindungspunkt eines mit der Bezugsspannungsklemme (BP) verbundenen, als Diode geschalteten Transistors (M43) und eines dazu in Serie liegenden, als Widerstand geschalteten dritten Verarmungstransistors (M42) angeschlossen ist, die wiederum in Serie zum Ausgangskreis eines vom Teilerpunkt des Spannungsteilers (M40,Rp) gesteuerten dritten Steuertransistors (M41) liegen.

10. Anordnung nach Anspruch 1 bis 10,
**dadurch gekennzeichnet,**
daß die Ausgangskreise der Ausgangstransistoren (M10,M11) der Stromspiegel und des schaltbaren Transistors (M9) der Ladestromquelle in Serie liegen.

11. Anordnung nach Anspruch 1 bis 10,
**dadurch gekennzeichnet,**
daß der Steuereingang des ersten Steuertransistors (M4) über einen zur Pegelanpassung dienenden Spannungsteiler (M1 bis M3) mit der Steuerspannungsklemme (Vst) verbunden ist.

12. Anordnung nach Anspruch 1 bis 11,
**dadurch gekennzeichnet,**
daß der Steuereingang des ersten Steuertransistors (M4) mit dem Verbindungspunkt der Serienschaltung eines als Widerstand geschalteten vierten Verarmungstransistors (M1) und eines als Diode geschalteten Pegeltransistors (M2) verbunden ist und in Serie zum Pegeltransistor (M2) ein als Widerstand geschalteter fünfter Verarmungstransistor (M3) liegt, wobei der Verbindungspunkt an die Steuerspannungsklemme (Vst) angeschlossen ist.

13. Anordnung nach Anspruch 1 bis 12,
**dadurch gekennzeichnet,**
daß die Kontrolleinrichtung (K;ST,TR) einen Schmitt-Trigger mit Inverter (ST) umfaßt, dessen Eingang an der ersten Klemme (A) liegt und dessen Ausgang über einen Treiber (TR) mit den Steuereingängen des schaltbaren Transistors (M9) der Ladestromquelle und des Schalttransistors (M12) sowie einen zusätzlichen Ausgangstreiber (ATR) mit der Ausgangsklemme (Vf) der Schaltungsanordnung verbunden ist.

14. Anordnung nach Anspruch 1 bis 13,
**dadurch gekennzeichnet,**
daß eine über eine Steuerklemme (SE) gesteuerte Ab-und Umschalteinrichtung vorgesehen ist, die den Treiber (TR) und die Lade-und Entladestromquelle (SQ) signalmäßig abschaltet und den Ausgangstreiber (ATR) mit seinem Eingang an die erste Klemme (A) legt, indem die Eingangskreise der Transistoren (M5,M11) des ersten Stromspiegels und der Ausgang des Schmitt-Triggers mit Inverter (ST) über je einen Transistor (M28,M29) mit der Bezugsspannungsklemme (BP) verbunden werden und der Eingang des Ausgangstreibers (ATR) über eine Transistorumschalteinrichtung (IES) vom Ausgang des Treibers (TR) an die erste Klemme (A) umgeschaltet wird.

FIG 1

VP

I1

S1

S2

Vst

I2

A

C

BP

K

Vf

FIG 4

f / f$_0$

2,5

2

1,5

1

0,5

k$_0$ = 3,7 kHz/mV

k$_0$ = 4,2 kHz/mV

3

2

1

1    2    3    4    Ust/V

# FIG 2

FIG 3

0 243 878

$\uparrow \; \hat{=} \; VP$

$\downarrow \; \hat{=} \; BP$

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 7, Nr. 107 (E-174)[1252], 11. Mai 1983; & JP-A-58 29 217 (FUJITSU K.K.) 21-02-1983 <br> * Zusammenfassung * | 1,4,6, 10,13 | H 03 K 3/354 <br> H 03 K 3/023 |
| | --- | | |
| A | US-A-4 321 561 (PAYNE et al.) <br><br> * Spalte 2, Zeile 24 - Spalte 8, Zeile 56; Figuren 1,2 * | 1,4,6, 10 | |
| | --- | | |
| A | PATENT ABSTRACTS OF JAPAN, Band 7, Nr. 288 (E-218)[1433], 22. Dezember 1983; & JP-A-58 165 414 (HITACHI SEISAKUSHO K.K.) 30-09-1983 <br> * Zusammenfassung * | 1,2,4, 6,10, 13 | |
| | --- | | **RECHERCHIERTE SACHGEBIETE (Int. Cl.4)** |
| A | US-A-3 904 988 (HSIAO) <br><br> * Spalte 2, Zeilen 1-42; Spalte 7, Zeilen 53-66; Figuren 1,6 * | 1,4,6, 10 | H 03 K |
| | --- | | |
| A | DE-A-3 017 928 (RCA) <br><br> * Seite 7, Zeile 16 - Seite 12, Zeile 9; Figuren 1,2 * | 1,4,6, 10 | |
| | ---               -/- | | |

Der vorliegende Recherchenbericht wurde für alle Patentansprüche erstellt.

| Recherchenort <br> DEN HAAG | Abschlußdatum der Recherche <br> 10-08-1987 | Prüfer <br> BALBINOT H. |
|---|---|---|

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

**Europäisches Patentamt**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-2 049 535 (COMMISSARIAT A L'ENERGIE ATOMIQUE) <br> * Seite 2, Zeile 26 - Seite 4, Zeile 27; Figuren 1,2 * | 1,2 | |
| | ----- | | |
| | | | RECHERCHIERTE SACHGEBIETE (Int. Cl 4) |

Der vorliegende Recherchenbericht wurde für alle Patentansprüche erstellt

| Recherchenort | Abschlußdatum der Recherche | Prüfer |
|---|---|---|
| DEN HAAG | 10-08-1987 | BALBINOT H. |